# EUROPEAN PATENT APPLICATION

(11) **EP 2 068 252 A2**
(43) Date of publication of application: **10.06.2009**
(21) Application number: 08168606.5
(22) Date of filing: 07.11.2008
(51) Int. Cl.: G06F 17/22

(54) **Method and apparatus for encoding and decoding XML document using path code**

(30) Priority: 09.11.2007 KR 20070114418; 09.05.2008 KR 20080043539
(71) Applicant: Electronics and Telecommunications Research Institute, Daejeon 305-700 (KR); Kookmin University Industry Academy Cooperation Foundation, Seoul 136-702 (KR)
(72) Inventor: Yeom, Jihyeon, Gyeonggi-do 472-709 (KR); Lim, Seong Yong, Daejeon 302-777 (KR); Kim, Hui Yong, Daejeon 305-755 (KR); Lee, Han Kyu, Daejeon 302-781 (KR); Hong, Jin Woo, Daejeon 305-340 (KR); Kim, Hyeokman, Seoul 135-786 (KR)
(74) Representative: Betten & Resch

(57) **Abstract**

The present invention relates to a method and apparatus for encoding and decoding an Extensible Markup Language (XML) document using a path code. A method of encoding an XML document valid in a schema in an XML schema language, the method comprising: retrieving all elements and attributes including character data in the XML document; extracting an Xpath of the retrieved elements or attributes; and converting the extracted Xpath into a predetermined path code, the path code being previously set based on a path code assignment scheme, using an Xpath of an element and attribute.

## Description

The present invention relates to a method and apparatus for encoding and decoding an Extensible Markup Language (XML) document using a path code.

This work was supported by the IT R&D of MIC/IITA. [2006-S-082-02, Development of Digital Multimedia Broadcasting Technology for Personalized Broadcasting]

In a terrestrial Digital Multimedia Broadcasting (DMB) environment, a huge amount of data may not be transmitted due to a narrow bandwidth. Also, text-type data such as an Extensible Markup Language (XML) document may not be transmitted. Accordingly, XML-based data information is binary-encoded based on a Transport Protocol Experts Group (TPEG) binary encoding format, and transmitted to a DMB network in real time in a traffic information service such as TPEG.

A terrestrial DMB, Electronic Program Guide (EPG), TPEG, and the like are data represented in an XML document among metadata transmitted to a current domestic terrestrial DMB network. A binary encoding format of each data described above is separately standardized. For example, a binary encoding scheme of TPEG and EPG uses a basic structure of a tag, length, and data, and assigns a tag code to all elements and attributes for encoding. Accordingly, when encoding an XML document, a tag code is assigned to all elements in all elements and attributes. Here, assigning a tag code to an unnecessary element is continuously repeated, which causes loss of compressibility.

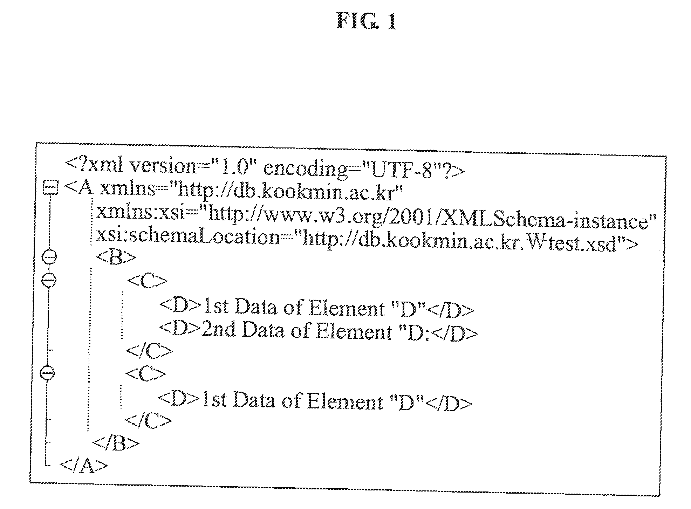

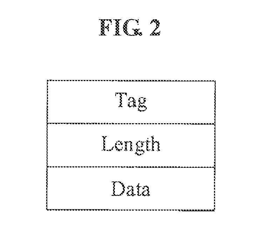

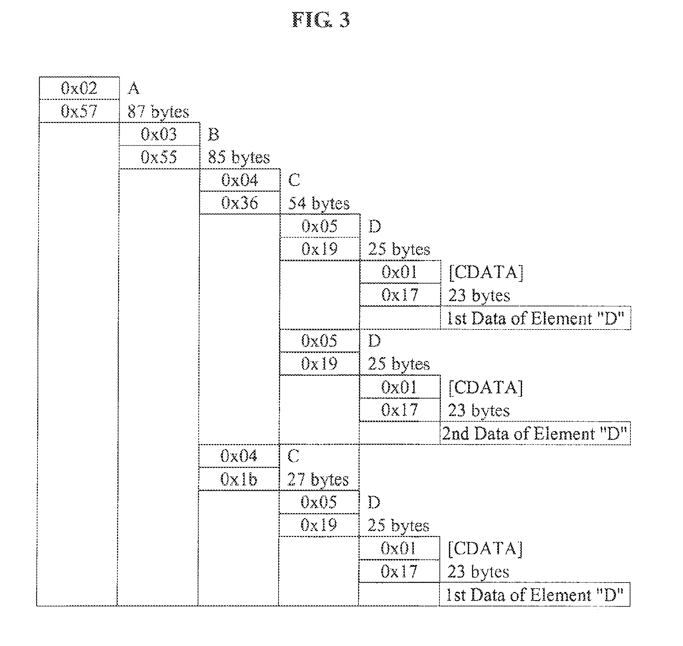

FIG. 1 is a diagram illustrating an example of a text-type XML document. FIG. 2 is a diagram illustrating a basic structure of binary encoding with respect to an XML document used in a TPEG and EPG. FIG. 3 is a diagram illustrating a tag code assignment method with respect to the XML document illustrated in FIG. 1 using the basic structure of FIG. 2 in a conventional art.

Referring to FIGS. 1 through 3, the XML document includes elements A, B, C, and.

According to the conventional tag code assignment method in a binary encoding scheme of the XML document, a tag code is assigned to all the elements A, B, C, and D. For example, tag codes "0x02", ""0x03, "0x04", and "0x05" are assigned to the elements A, B, C, and D, respectively. Also, content of each of the elements A, B, C, and D is encoded. Although the only element D includes character data, a tag code is assigned to the element B and element C as well. That is, unnecessary tag code assignment is repeated, and thus compressibility may decrease. Accordingly, a more efficient tag code assignment method is required.

The present invention provides a method and apparatus for encoding and decoding an Extensible Markup Language (XML) document which assigns a path code to an Xpath of all attributes and elements selected from elements defined in a schema in an XML schema, and thereby may reduce an unnecessary tag code assignment and increase compressibility.

According to an aspect of the present invention, there is provided a method of assigning a path code to an attribute and element defined in a schema in an Extensible Markup Language (XML) schema language, the method including: assigning a unique path code to an Xpath of each element, each of the elements being selected from all elements defined in the schema; and assigning a unique path code to an Xpath of each of all attributes defined in the schema.

According to another aspect of the present invention, there is provided a method of encoding an XML document valid in a schema in an XML schema language, the method including: retrieving all elements and attributes including character data in the XML document; extracting an Xpath of the retrieved elements or attributes; and converting the extracted Xpath into a predetermined path code, the path code being previously set based on a path code assignment scheme using an Xpath of an element and attribute.

According to another aspect of the present invention, there is provided a method of decoding an XML document encoded based on a path code, the method including: extracting a path code from the encoded XML document; retrieving an Xpath corresponding to the extracted path code in a predetermined path code table, the path code table being previously set based on a path code assignment scheme using an Xpath of an element and attribute; and selectively restoring the element or attribute based on an occurrence indicator of elements included in the retrieved Xpath.

The above and/or other aspects and advantages of the present invention will become apparent and more readily appreciated from the following detailed description, taken in conjunction with the accompanying drawings of which:
FIG. 1 is a diagram illustrating an example of a text-type Extensible Markup Language (XML) document;
FIG. 2 is a diagram illustrating a basic structure of binary encoding with respect to an XML document used in a Transport Protocol Experts Group (TPEG) and Electronic Program Guide (EPG);
FIG. 3 is a diagram illustrating a tag code assignment method with respect to the XML document illustrated in FIG. 1 using the basic structure of FIG. 2 in a conventional art;
FIG. 4 is a block diagram illustrating a configuration of an apparatus for encoding an XML document according to an embodiment of the present invention;
FIG. 5 is a block diagram illustrating a configuration of an apparatus for decoding an XML document according to an embodiment of the present invention;
FIG. 6 is a diagram illustrating a data structure used when encoding an XML document according to an embodiment of the present invention;
FIG. 7 is a flowchart illustrating a path code assignment scheme;
FIG. 8 is a diagram illustrating an example of a schema in an XML schema;
FIG. 9 is a diagram illustrating schema definition;
FIG. 10 is a diagram illustrating a path code table showing a path code assigned to an Xpath of the element and attribute of FIG. 9;
FIG. 11 is a diagram illustrating an example of data encoder type (DET);
FIG. 12 is a diagram illustrating an encoding method based on length;
FIG. 13 is a flowchart illustrating a method of encoding an XML document;
FIG. 14 is a flowchart illustrating a method of decoding an XML document; and
FIG. 15 is a diagram illustrating an example of multiple occurrence indicator (MOI) of all elements included in an Xpath of an element or attribute in an XML document.

Reference will now be made in detail to embodiments of the present invention, examples of which are illustrated in the accompanying drawings, wherein like reference numerals refer to the like elements throughout The embodiments are described below in order to explain the present invention by referring to the figures.

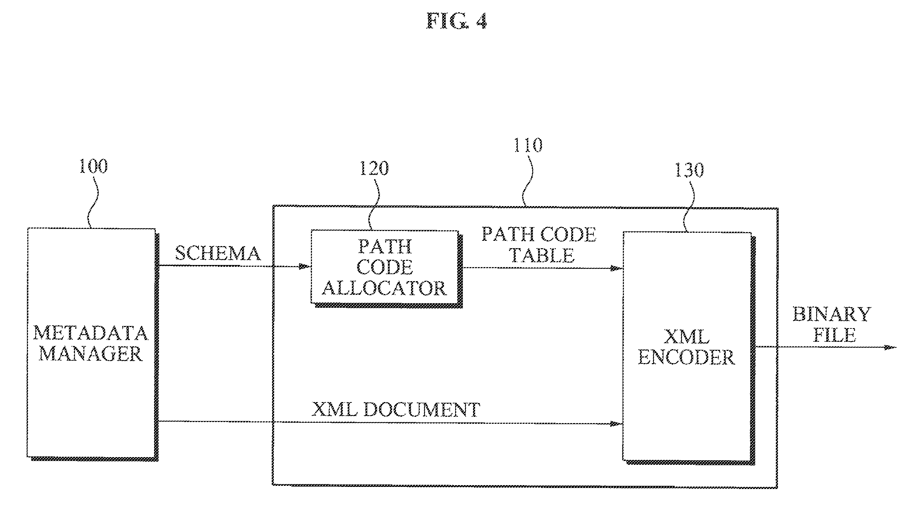

FIG. 4 is a block diagram illustrating a configuration of an apparatus 110 for encoding an Extensible Markup Language (XML) document according to an embodiment of the present invention.

Referring to FIG. 4, the apparatus 110 includes a path code allocator 120 and an XML encoder 130.

The path code allocator 120 receives a schema from a metadata manager 100 and assigns a path code to an element and attribute defined in a schema. That is, the path code allocator 120 assigns the path code to an Xpath of all attributes and selected elements, and generates a path code table.

The XML encoder 130 receives an XML document from the metadata manager 100 and retrieves all elements and attributes including character data in the XML document. Also, the XML encoder 130 converts an Xpath of the retrieved elements or attributes into a path code to encode. The path code is defined in the path code table.

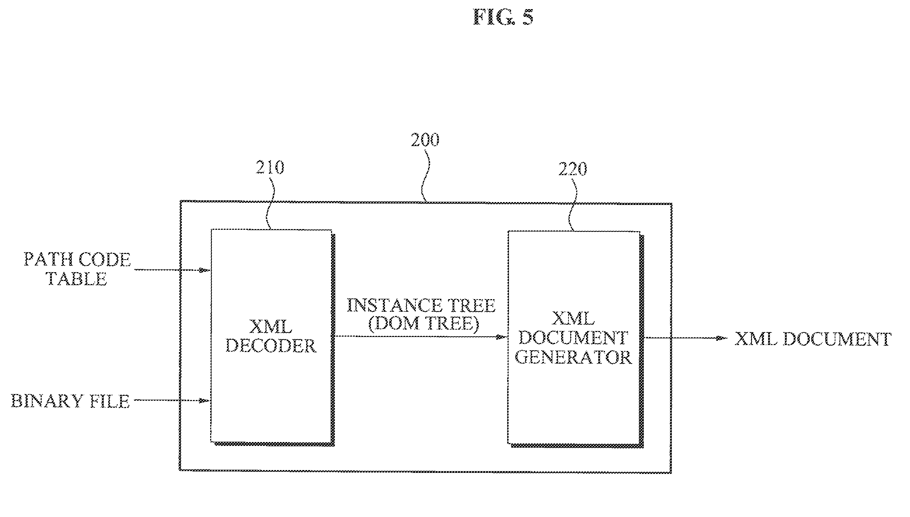

FIG. 5 is a block diagram illustrating a configuration of an apparatus 200 for decoding an XML document according to an embodiment of the present invention.

Referring to FIG. 5, the apparatus 200 includes an XML decoder 210 and an XML document generator 220.

The XML decoder 210 receives an encoded XML document and a path code table. The path code table is generated based on a path code assignment scheme using an Xpath of an element and attribute.

The XML decoder 210 extracts a path code from the encoded XML document, and retrieves an Xpath corresponding to the extracted path code in a predetermined path code table. Also, the XML decoder 210 selectively restores the element or attribute based on an occurrence indicator of elements included in the retrieved Xpath, and generates an instance tree.

The XML document generator 220 generates an XML document from the generated instance tree.

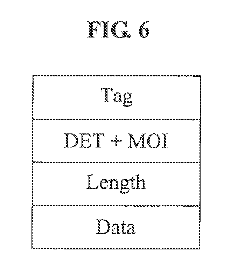

FIG. 6 is a diagram illustrating a data structure used when encoding an XML document according to an embodiment of the present invention.

Referring to FIG. 6, the data structure includes a path, data encoder type multiple occurrence indicator (DET-MOI), length, and data filed. Each of the path, DET-MOI, and length may be basically expressed in 1 byte.

A path code is a unique value assigned to an Xpath of an element and attribute defined in a schema in an XML schema language, In this instance, the element defines a path code that may be represented in an XML document in the schema. The attribute defines a feature of an element and existence of the feature in the schema.

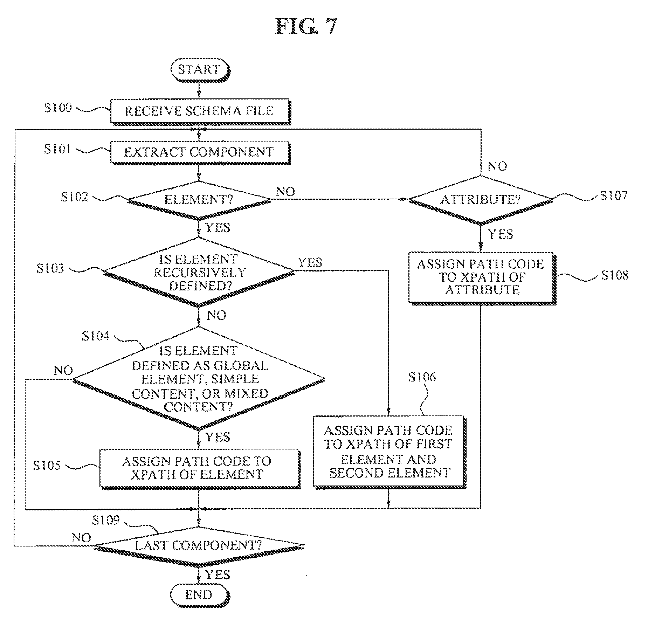

Hereinafter, a path code assignment scheme is described in detail with reference to FIG. 7.

FIG. 7 is a flowchart illustrating a path code assignment scheme.

Referring to FIG. 7, a path code allocator receives a schema file in operation S100.

In operation S101, the path code allocator extracts a component defined in the schema.

The component is included in the schema and includes an attribute, element, and the like.

In operation S 102, the path code allocator determines whether the extracted component is an element.

In operation S107, when the extracted component is not the element, the path code allocator determines whether the component is an attribute. When the component is the attribute, the path code allocator assigns a path code to an Xpath of the attribute in operation S108.

When the extracted component is the element, the path code allocator selectively assigns the path code. Conversely, when the extracted component is the attribute, the path code allocator assigns the path code to all attributes.

In operation S103, when the extracted component is the element, the path code allocator confirms definition of the element.

In operation S104, the path code allocator determines whether the confirmed element is defined as a global element, simple content, or mixed content. In operation S105, when the confirmed element is defined as the global element, simple content, or mixed content, the path code allocator assigns a unique path code to an Xpath of the element.

In this instance, the global element indicates an element defined as a direct child element of a "schema" root element in the schema.

The simple content indicates an element including character data.

The path code allocator assigns the path code to only an element defined as the simple content. However, the path code allocator does not assign the path code to an Xpath of an element defined as element content. The element content is an element located between the global element and the element including the character data.

Also, the mixed content indicates an element including the character data as well as another child element. The mixed content may be defined by setting a mixed feature of a complex type as "true" in the schema in an XML schema.

Accordingly, the path code allocator may determine whether a corresponding element is defined as the mixed content using the mixed feature of the complex type.

In operation S106, when the confirmed element is recursively defined, the path code allocator assigns the unique path code to an Xpath of a first element and an Xpath of a second element. The first element is an element where the recursion starts and the second element is an element where the recursion ends.

In this instance, the recursively defined element may indicate an element repeatedly defined as a child element or as a descendent element of the element.

As described above, after assigning the path code, the path code allocator repeatedly performs the path code assignment process with respect to a subsequent component until a last component is extracted in operation S108.

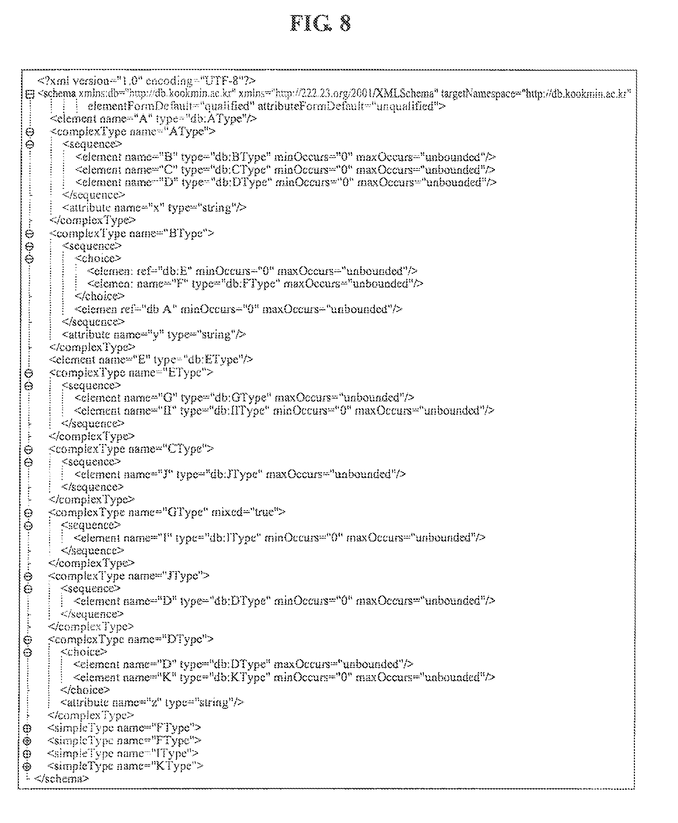

Hereinafter, a path code assignment method according to an embodiment of the present invention is described in detail with reference to FIG. 8.

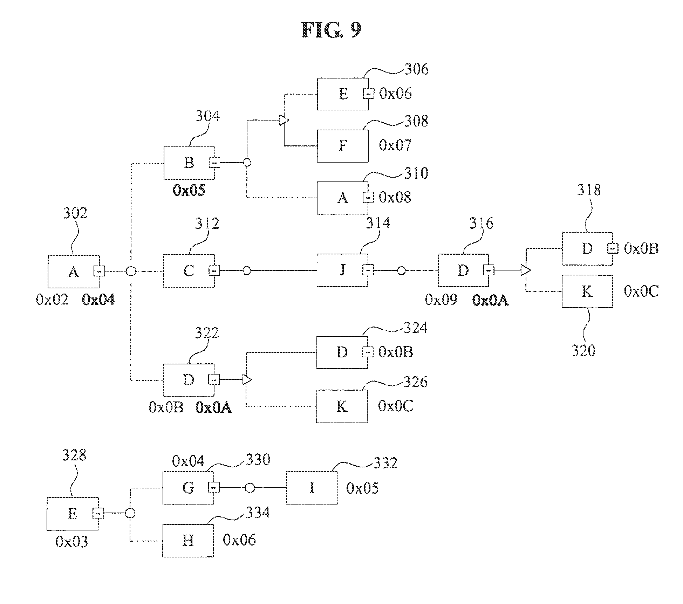

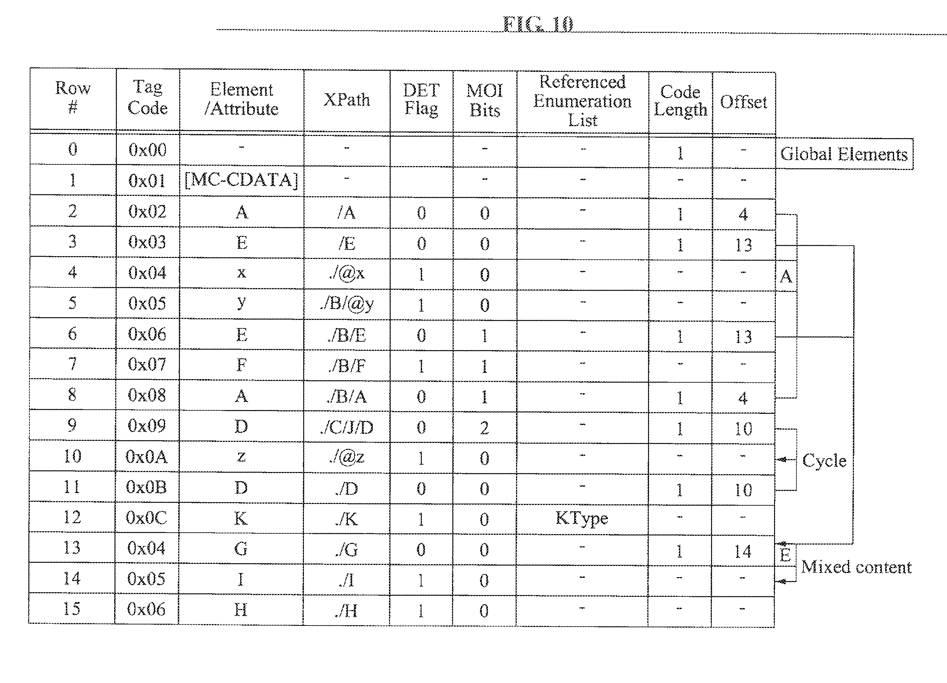

FIG. 8 is a diagram illustrating an example of a schema in an XML schema. FIG. 9 is a diagram illustrating schema definition. FIG. 10 is a diagram illustrating a path code table showing a path code assigned to an Xpath of the element and attribute of FIG. 9.

Referring to FIGS. 8 through 10, an element A 302 and an element E 328 are global elements. Elements F 308, K 320, K 326, I 312, and H 334 are elements including character data. Elements D 316, 318, 322, and 324 are elements recursively defined. Also, an element G 330 is an element defined as mixed content,

First, a path code allocator assigns a path code "0x02" and a path code "0x03" to an Xpath "/A" of the element A 302 and an Xpath of the element E 328, respectively. Also, the path code allocator assigns a path code "0x08" and a path code "0x06" to an Xpath "./B/A" of the area element 310 and an Xpath "./B/E" of the area element 306, respectively. Also, the path code allocator assigns path codes "0x07", '"0x0C", "0x05", and "0x06" to an Xpath "./B/F" of the element F 308, an Xpath "./K" of the element K 320 and 326, an Xpath "./I" of the element I 332, and an Xpath "./H" of the element H 334, respectively.

In this instance, a unique path code is to be assigned to the global elements. Also, a unique path code is to be assigned to area elements within on the global elements. Accordingly, a same path code may be assigned to the area elements defined as a child element of each of the global elements. For example, path codes different from each other are to be assigned to an Xpath of each of the element A 302 and the element E 328, Also, a unique path code is to be assigned to an Xpath of each of the element A 302 and the elements E 306, F 308, A 310, D 318, and the like. The elements E 306, F 308, A 310, and D 318 are child elements of the element A 302. However, the same path code "0x06" may be assigned to an Xpath of the element E 306, which is a child element of the element A 302, and an Xpath of the element H 334 which is a child element of the element E 328. Also, when assigning, the same path code is assigned to the same Xpath. Accordingly, since the elements K 320 and 326 have the same Xpath "./K", the same path code "0x0C" is assigned.

The path code allocator assigns a path code to an Xpath of the elements D 316, 318, 322, and 324 recursively defined. Specifically, the path code allocator assigns a path code to an Xpath of first elements 316 and 322 and an Xpath of second elements 318 and 324. The first elements 316 and 322 indicate an element where a recursion starts, and the second elements 318 and 324 indicate an element where the recursion ends.

For example, the path code allocator assigns a path code "0x09" to an Xpath "./C/J/D" of the element D 316 where the recursion starts, and a path code "0x0B'" to an Xpath "./D" of the element D 318 where the recursion ends. Also, the path code allocator assigns the path code "0x0B" to the Xpath "./D" of the element D 322 where the recursion starts, and the path code "0x0B" to the Xpath "./D" of the element D 324 where the recursion ends. In this instance, the same path code "0x0B" is assigned to the same Xpath "./D".

Also, the path code allocator assigns a path code "0x04" to an Xpath "./G" of the element G 330 defined as the mixed content, and assigns a predetermined unique fixed value (for example, 0x01) indicating that character data of a corresponding dement is character data of the mixed content.

Also, the path code allocator assigns a path code to an Xpath of all attributes defined in a schema. For example, the path code allocator assigns a path code "0x05" to an Xpath "./B/@x" of an attribute x of the element B 304, and a path code "0x0A" to an Xpath "./@z" of an attribute z of the element D 316.

According to an embodiment of the present invention, a path code is assigned to an Xpath of elements selected from all the elements. Also, a path code is not assigned to an Xpath of elements B 304, C 312, and J 314 defined as element content. Accordingly, compressibility may increase in comparison to a method of assigning a tag code to all elements.

Hereinafter, 'DET-MOI' of FIG. 6 is described in detail.

The DET-MOI includes DET and MOI.

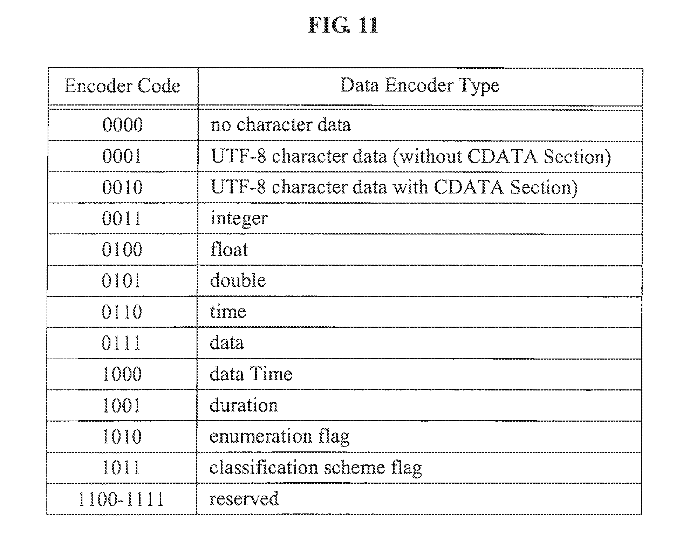

The DET indicates an encoder which encodes character data of an element or a value of attribute with respect to an element or attribute including character data. The DET is illustrated in FIG. 11 as an example, and may be basically represented in four bits.

The MOI indicates an occurrence indicator of all elements included in an Xpath of an element or attribute in an XML document.

The MOI sequentially assigns one bit to each element node located between a starting node (context node) and a last node (a corresponding element or attribute) of an Xpath.

Specifically, when decoding the Xpath of the element or attribute converted into the path code, "1" or "0" is assigned depending on whether an element corresponding to each bit is generated. Specifically, "1" is assigned when an element corresponding to a specific bit is to be generated, and "0" is assigned when the element is not to be generated.

When decoding an encoded XML document, MOI functions as a flag associated with all elements included in an Xpath are generated. In this instance, when a last node of the Xpath is an element, the element is always to be generated. Accordingly, one bit having a value of "1" is not assigned, and is processed as a default "1" when decoding the last node of the Xpath.

Hereinafter, 'length' of FIG. 6 is described in detail.

The length indicates length of data of an element and attribute corresponding to a path code. When an element is defined as element content, the length includes byte length of data, overall length, DET-MOI, and path corresponding to a lower-layer element. Length of an element including only character data indicates length of character data, and length of an attribute indicates length of a value of the attribute.

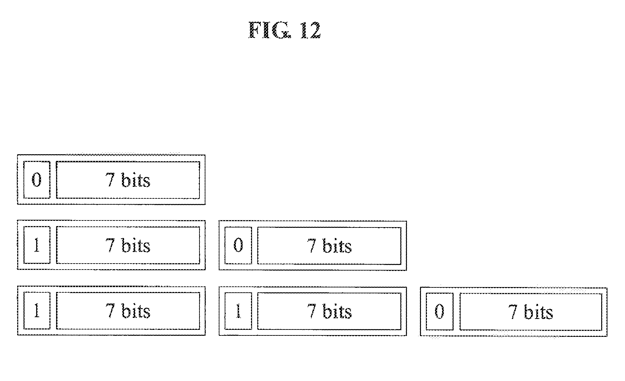

FIG. 12 is a diagram illustrating an encoding rule based on length.

Referring to FIG. 12, when a value of a length is 0x00 ∼ 0x7f, a first bit value is represented as "0", and the length is encoded as one byte as is, In this instance, the first bit functions as a flag associated with length, when adding a subsequent one byte.

However, when a value of a length exceeds 0x7f, the length is encoded by extending to two or three bytes. When the length is extended to two bytes, a first bit value of a first byte is set as "1", and a first bit value of a second byte is set as "0". Similarly, when a value of a length is extended to three bytes, first bit values of a first byte and second byte are set as "1", and a first bit value of a third byte is set as "0" to encode the length.

'Data' of FIG. 6 indicates actual data such as character data.

A data structure used when encoding an XML document is not limited to the data structure of FIG. 6. The XML document may be encoded in a data structure including a path, length, MOI, and data field excluding DET.

Hereinafter, a method of encoding an XML document valid in a schema in an XML schema language is described.

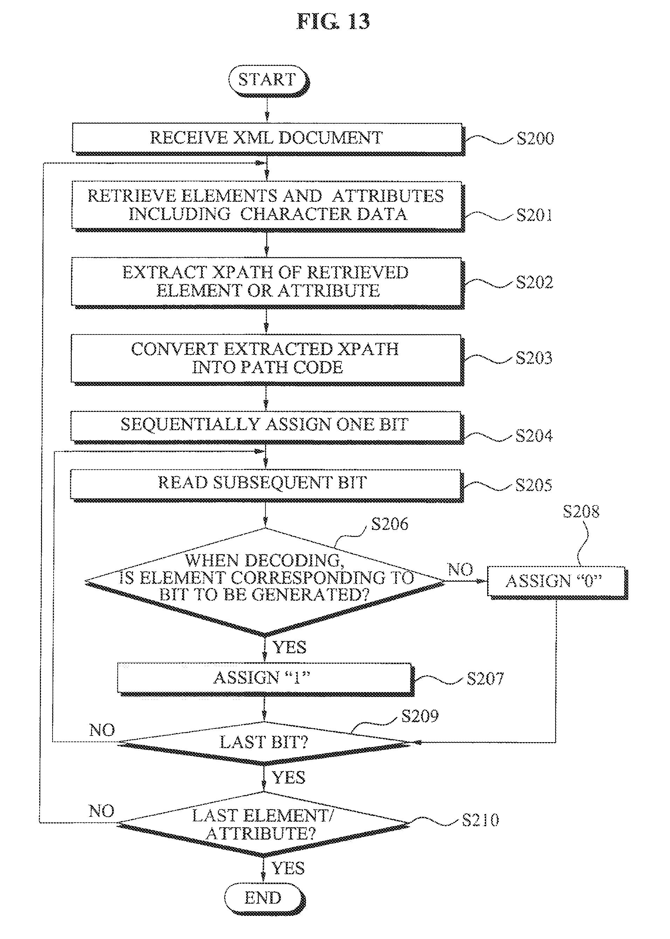

FIG. 13 is a flowchart illustrating a method of encoding an XML document.

Referring to FIG. 13, in operation S200, an XML encoder receives an XML document.

In operation S201, the XML encoder retrieves an element or attribute including character data in the XML document. In operation S202, the XML encoder extracts an Xpath of the retrieved element or attribute. In operation S203, the XML encoder converts the extracted Xpath into a path code.

In operation S204, the XML encoder sequentially assigns one bit to each of all element nodes located between a starting node and last node of the Xpath to show MOI. The MOI is an occurrence indicator of all elements included in the Xpath.

Specifically one bit is read from the MOI in operation S205. When decoding the element converted into the path code and an element corresponding to the bit is to be generated, the XML encoder assigns "1" to the bit in operation S206 and operation S207. Also, when decoding the element converted into the path code and an element corresponding to the bit is not to be generated, the XML encoder assigns "0" to the bit in operation S206 and operation S208.

In operation S209, it is determined whether a bit is a last bit in the MOI. when it is determined that the bit is not the last bit, the XML encoder returns to operation S205.

in operation S210, it is determined whether the retrieved element or attribute is a last element or attribute. When it is determined that the retrieved element or attribute is not the last element or attribute, the XML encoder returns to operation S201.

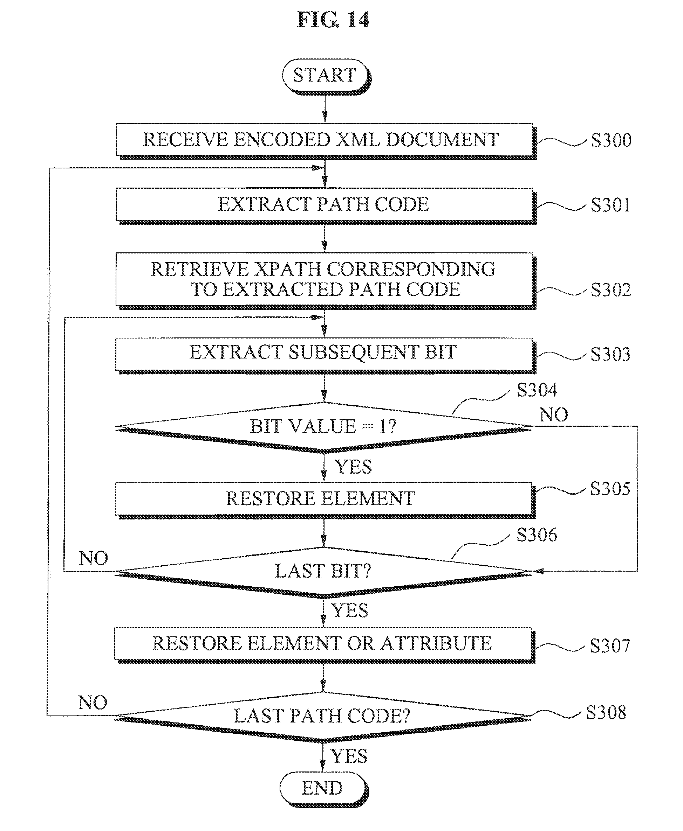

FIG. 14 is a flowchart illustrating a method of decoding an XML document.

Referring to FIG. 14, in operation S300, an XML decoder receives an encoded XML document.

In operation S301, the XML decoder extracts a path code from the encoded XML document. In operation S302, the XML decoder retrieves an Xpath corresponding to the extracted path code.

The XML decoder selectively restores an element or attribute included in the retrieved Xpath based on an MOI.

In operation S303, a subsequent bit is extracted from the MOI. When it is determined that a bit value is "1" in operation S304, an element corresponding to the bit is restored in operation S305. When it is determined that a bit is not a last bit in the MOI in operation S306, the XML decoder returns to operation S303.

In operation S307, the XML decoder restores an element or attribute corresponding to a last node of the retrieved Xpath.

As described above, in operation S308, the XML decoder determines whether the extracted path code is a last path code, and when the extracted path code is not determined as the last path code, the XML decoder returns to operation S301.

Hereinafter, a method of decoding an XML document using an MOI is described in detail.

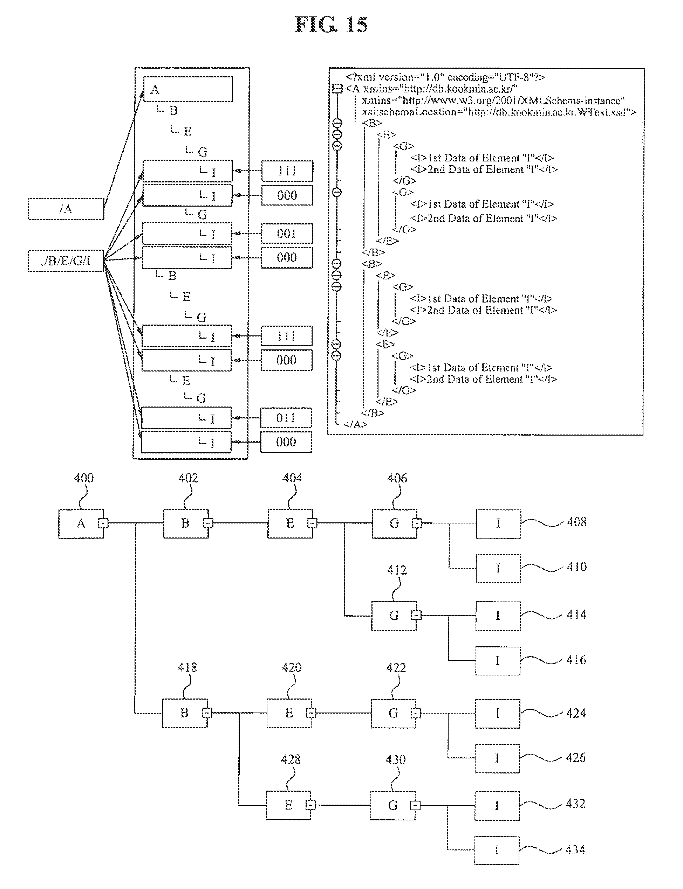

FIG. 15 is a diagram illustrating an example of MOI of all elements included in an Xpath of element or attribute in an XML document.

Referring to FIG. 15, ain element A 400 is a global element, and elements B 402, 418, E 404, 420, G 406, 412, and 1408, 410 are child elements of the element A 400, which forms a nested structure.

An Xpath of the element I including character data is ",/B/E/G/I". A method of showing an occurrence indicator of all elements included in the Xpath is described.

One bit is assigned to each element node located between an element A which is a starting node of the Xpath and an element I which is a last node of the Xpath. Three bits are assigned to show an occurrence indicator of element nodes B, E, and G. Also, when elements B, E, and G are to be generated when decoding, "1" is assigned, and "0" is assigned when the elements are not to be generated.

For example, in "111" which is an MOI value of a first element I 408, each bit sequentially indicates the elements B 402, E 404, and G 406. Since each bit value is assigned with "1", elements B 402, E 404, and G 406 are all generated when decoding.

In "000" which is an MOI value of a second element I 410, since each bit value is assigned with "0", the elements B 402, E 404, and G 406 are not generated when decoding. Accordingly, a relationship between a first element I 408 and second element I 410 is a sibling relationship.

Since an MOI value of a third element I 414 is "001", only element G 412 corresponding to a bit value of "1" is generated. A decoding process is performed with respect to an MOI of a fourth through sixth element I 416, 424, 426, as described above.

Since an MOI value of a seventh element I 432 is "011", an element E 428 and element G 430 corresponding to a bit value of "1" are generated. A decoding process is performed with respect to an MOI of an eighth element I 434, as described above.

According to an embodiment of the present invention, a path code is not assigned to all elements, a unique path code is assigned to an Xpath of selected elements, and thus unnecessary path code assignment may decrease and compressibility may increase.

The data collecting method according to the above-described embodiment of the present invention may be recorded in computer-readable media including program instructions to implement various operations embodied by a computer. The media may also include, alone or in combination with the program instructions, data files, data structures, and the like. The media and program instructions may be those specially designed and constructed for the purposes of the present invention, or they may be of the kind well-known and available to those having skill in the computer software arts. Examples of computer-readable media include magnetic media such as hard disks, floppy disks, and magnetic tape; optical media such as CD ROM disks and DVD; magneto-optical media such as optical disks, and hardware devices that are specially configured to store and perform program instructions, such as read-only memory (ROM), random access memory (RAM), flash memory, and the like. Examples of program instructions include both machine code, such as produced by a compiler, and files containing higher level code that may be executed by the computer using an interpreter. The described hardware devices may be configured to act as one or more software modules in order to perform the operations of the above-described embodiments of the present invention.

According to an embodiment of the present invention, a method and apparatus for encoding and decoding an XML document assigns a path code to an Xpath of all attributes and elements selected from elements and attributes defined in a schema in an XML schema, and thereby may reduce an unnecessary tag code assignment and increase compressibility.

Although a few embodiments of the present invention have been shown and described, the present invention is not limited to the described embodiments. Instead, it would be appreciated by those skilled in the art that changes may be made to these embodiments without departing from the principles and spirit of the invention, the scope of which is defined by the claims and their equivalents.

## Claims

1. A method of assigning a path code to an attribute and element defined in a schema in an Extensible Markup Language (XML) schema language, the method comprising:
assigning a unique path code to an Xpath of each element, each of the elements being selected from all elements defined in the schema; and
assigning a unique path code to an Xpath of each of all attributes defined in the schema.

2. The method of claim 1, wherein the assigning of the unique path code to the Xpath of each of the selected elements comprises:
determining whether all the elements are defined as a global element; and
assigning the unique path code to an Xpath of the global element when all the elements are defined as the global element.

3. The method of claim 1, wherein the assigning of the unique path code to the Xpath of each of the selected elements comprises:
determining whether all the elements are defined as simple content including character data; and
assigning the unique path code to an Xpath of each of the elements when all the elements are defined as the simple content.

4. The method of claim 1, wherein the assigning of the unique path code to the Xpath of each of the selected elements comprises:
determining whether all the elements are recursively defined; and
assigning the unique path code to an Xpath of a first element and an Xpath of a second element when all the elements are recursively defined, the first element being an element where the recursion starts, the second element being an element where the recursion ends.

5. The method of claim 1, wherein the assigning of the unique path code to the Xpath of each of the selected elements comprises:
determining whether all the elements are defined as mixed content; and
assigning the unique path code to an Xpath of the elements including the mixed content when all the elements are defined as the mixed content.

6. A method of encoding an XML document valid in a schema in an XML schema language, the method comprising;
retrieving all elements and attributes including character data in the XML document;
extracting an Xpath of the retrieved elements or attributes; and
converting the extracted Xpath into a predetermined path code, the path code being previously set based on a path code assignment scheme using an Xpath of an element and attribute.

7. The method of claim 6, wherein the path code assignment scheme cot-riprises:
assigning a unique path code to an Xpath of each element, each of the elements being selected from all the elements defined in the schema; and
assigning a unique path code to an Xpath of each of all the attributes defined in the schema.

8. The method of claim 6 or 7, further comprising:
generating an occurrence indicator of all elements included in the Xpath converted into the path code.

9. The method of claim 8, wherein the generating comprises:
sequentially assigning one bit to each of all element nodes located between a starting node and last node of the Xpath.

10. The method of claim 9, wherein the sequentially assigning comprises:
when decoding the Xpath of the element converted into the path code, assigning "1" when an element corresponding to the bit is to be generated; and assigning "0" when the element is not to be generated.

11. A method of decoding an XML document encoded based on a path code, the method comprising:
extracting a path code from the encoded XML document;
retrieving an Xpath corresponding to the extracted path code in a predetermined path code table, the path code table being previously set based on a path code assignment scheme using an Xpath of an element and attribute; and
selectively restoring the element or attribute based on an occurrence indicator of elements included in the retrieved Xpath.

12. The method of claim 11, wherein the selectively restoring comprises:
restoring an element corresponding to each bit of the occurrence indicator, only when a value of each bit is "1".

13. The method of claim 11, wherein the selectively restoring further comprises:
restoring an element or attribute, corresponding to a last node of the retrieved Xpath.

14. An apparatus for encoding an XML document valid in a schema in an XML schema language, the apparatus comprising:
a path code allocator assigning a path code to an element and attribute defined in the schema, and generating a path code table, the path code being previously set based on a path code assignment scheme using an Xpath of the element and attribute; and
an XML encoder retrieving all elements and attributes including character data in the XML document, converting an Xpath of the retrieved elements and attributes into a path code defined in the path code table, and encoding the Xpath.

15. An apparatus for decoding an XML document encoded based on a path code, the apparatus comprising:
a decoder retrieving an Xpath corresponding to an extracted path code in a predetermined path code table, selectively restoring an element or attribute based on an occurrence indicator of elements included in the retrieved Xpath, and generating an instance tree, the path code table being previously set based on a path code assignment scheme using an Xpath of an element and attribute; and
an XML document generator generating the XML document from the generated instance tree.
